# EUROPÄISCHE PATENTSCHRIFT

(11) **EP 1 746 719 B1**
(45) Veröffentlichungstag und Bekanntmachung des Hinweises auf die Patenterteilung: **14.11.2012**
(21) Anmeldenummer: 06014324.5
(22) Anmeldetag: 11.07.2006
(51) Int. Cl.: H03B 11/02, H01T 9/00

(54) **Mikrowellengenerator mit veränderbarer Frequenzabstrahlung**
Microwave generator with variable frequency radiation
Générateur de micro-ondes à radiation de fréquences variable

(30) Priorität: 22.07.2005 DE 102005034295
(43) Veröffentlichungstag der Anmeldung: 24.01.2007
(73) Patentinhaber: Diehl BGT Defence GmbH & Co. KG, 88662 Überlingen (DE)
(72) Erfinder: Staines, Geoffrey, Dr., San Diego, CA 92130 (US)
(74) Vertreter: Diehl Patentabteilung

(56) Entgegenhaltungen:
- GB-A- 619 958
- US-A- 3 748 528

## Beschreibung

Die Erfindung betrifft einen Mikrowellengenerator gemäß den Oberbegriffen der Hauptansprüche.

Ein derartiger Generator ist in der DE 1 01 51 565 B4 als mechanisch abstimmbares Resonanzsystem beschrieben, angewandt auf einen Mikrowellengenerator der in DE 1 03 286 B3 unter Bezugnahme auf DE 1 01 51 565 B4 funktional und konstruktiv näher erläuterten Art. Danach wird innerhalb eines durchschlagfest isolierenden röhrenförmigen Umgehäuses die auf Hochspannung aufgeladene Kapazität zwischen einer flaschenförmigen Innenelektrode und einer diese koaxial umgebenden, hohlzylindrischen Außenelektrode eines elektromechanischen Resonators über eine Funkenstrecke vor dem Boden der Innenelektrode entladen. Das führt zu einem steil einsetzenden und danach stark oszillierenden Stromfluss auch über eine an den Flaschenhals konzentrisch sich anschließende, zur Impedanzanpassung trichterförmig sich aufweitende Antenne. Der Entladestrom-Impuls von typisch nur wenigen Nanosekunden Länge führt zu breitbandiger Abstrahlung eines Mikrowellenspektrums im Bereich etwa von 200 bis 400 MHz mit derart hoher Energiedichte, dass in der näheren Umgebung aufgebaute Funkverbindungen zumindest beeinträchtigt und elektronische Schaltungen mit der Resonanzbedingung angepassten körperlichen Strukturen insbesondere eingangsseitig gestört oder sogar zerstört werden können.

Zur geometrischen Resonanzanpassung der mittleren Wellenlänge des abgestrahlten Spektrums an die Abmessungen besagter Schaltungen ist beim gattungsgemäßen Generator im Entladestromweg vor der Außenelektrode ein elektrischer Leiter variabler Länge vorgesehen. Die dort gezeigte Spindelführung zum axialen Verlagern einer Kurzschlussbrücke für die Längeneinstellung des Entladestromweges ermöglicht zwar eine stetige Variation der Schwerpunktfrequenz im abgestrahlten Spektrum, sie bedingt allerdings vergleichsweise großen und weitgehend ungenutzten Bauraum und ist auch mechanisch recht aufwendig. Andererseits ist im praktischen Einsatz ein solches Durchwobbeln gewöhnlich gar nicht erforderlich; häufig genügt eine vorübergehende Verlagerung der Schwerpunktfrequenz zum Beobachten der Wirkung einer momentanen Resonanzanpassung in einer bestimmten empfängerseitigen Konstellation.

In Erkenntnis dieser Gegebenheiten liegt vorliegender Erfindung die technische Problemstellung zugrunde, die Abstrahlfrequenz eines Mikrowellengenerators gattungsgemäßer Art mit konstruktiv deutlich weniger aufwendigen Mitteln wenigstens vorübergehend gezielt und wirksam beeinflussen zu können.

Diese Aufgabe ist erfindungsgemäß durch die Kombination der wesentlichen in den Hauptansprüchen angegebenen Merkmale gelöst. Danach wird der Mikrowellengenerator zwischen passiven Reflektoren beiderseits des Generators betrieben. Die dadurch eintretenden Überlagerungen von gegensinnig abgestrahlter und reflektierter Wellenenergie führen zu einer wünschenswerten Beeinflussung des Impulsverhaltens und damit der Schwerpunktfrequenz im abgestrahlten Spektrum. Dafür sollte die Resonanzfrequenz der Reflektoren derjenigen des Resonators im Generator möglichst gut entsprechen, was hinreichend gegeben ist, wenn die achsparallel zum Generator gemessene Länge der Reflektoren mit der Generatorlänge (aus Resonator und Trichterantenne) in etwa übereinstimmt.

Die Reflektorabmessungen quer zur Generator-Längsachse gehen nicht signifikant in das Verhalten des Abstrahlimpulses ein, weshalb der jeweilige Reflektor statt als Platte auch als zylindrischer Dipol, also einfach stabförmig ausgelegt sein kann. Ein teleskopierbarer Stab kleiner bzw. standardisierter Länge weist somit den Vorteil auf, infolge seiner Längenvariation leicht an die gegebene Baulänge des gerade verfügbaren Mikrowellengenerators angepasst werden zu können.

Von maßgeblichem Einfluss auf das abgestrahlte Spektrum ist dagegen der gegenseitige Abstand zwischen den abgestimmten Reflektoren, inmitten zwischen denen der Mikrowellengenerator betrieben wird. Denn eine Annäherung der beiderseitigen Reflektoren an den Generator führt zu einer zeitlichen Verlängerung des abgestrahlten Energieimpulses, allerdings ohne wesentliche Beeinflussung seiner Scheitelhöhe. Das besagt, dass der Betrieb zwischen den passiven Reflektoren zu einer Verstärkung der abzustrahlenden Energie und somit der Außenwirkung, etwa auf die besagte Schaltung, führt. Im Frequenzbereich bewirkt dieser Effekt ein Anheben der unteren Frequenzen im abgestrahlten Spektrum.

Wenn so über die Resonator-Einstellung die in Hinblick auf die gewünschte Wirkung optimale Frequenzabstrahlung aufgefunden wurde, kann der Mikrowellengenerator besonders einfach auf etwa dieses Schwingungsverhalten getrimmt werden, indem ein Koppelstück zwischen Resonator und Trichterantenne entsprechend gekürzt oder verlängert wird. Dazu können, unter Verlagerung der Antenne innerhalb des röhrenförmigen Umgehäuse, Koppelstücke unterschiedlicher Länge eingefügt werden; oder ein hohlzylindrisches Koppelstück ist teleskopförmig ausgelegt, um die Trichterantenne relativ zum Resonator besonders einfach in gewissen, durch die Länge des Umgehäuse konstruktiv vorgegebenen Grenzen verlagern zu können.

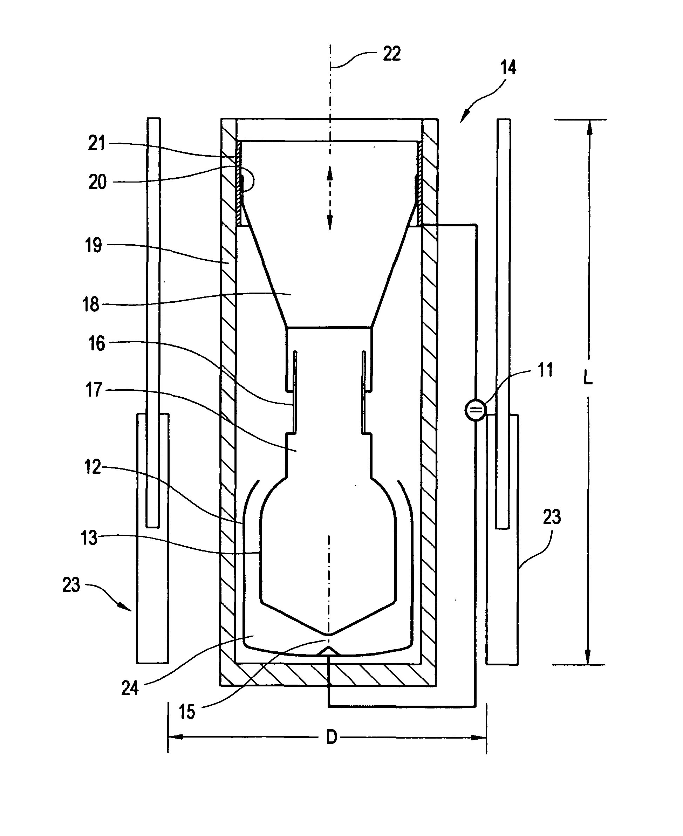

Bezüglich zusätzlicher Alternativen und Weiterbildungen wird noch auf die Unteransprüche verwiesen. Näheres zur erfindungsgemäßen Lösung ergibt sich auch aus der Zeichnung mit der unmaßstäblichen Prinzipskizze eines bevorzugten Realisierungsbeispieles und dessen nachstehender Beschreibung. Die einzige Figur der Zeichnung zeigt im Axial-Längsschnitt einen zwischen zwei passiven Reflektoren betriebenen Mikrowellengenerator mit konstruktiv variierbarem Abstand zwischen Resonator und im Umgehäuse axialverlagerbarer trichterförmiger Antenne.

Die aus einem Hochspannungs-Gleichstromgenerator 11 aufgeladene Kapazität zwischen rohrförmiger Außenelektrode 12 und flaschenförmiger Innenelektrode 13 des koaxial aufgebauten Mikrowellengenerators 14 entlädt sich am freien Stirnende der Innenelektrode 13 über eine Funkenstrecke 15, durch deren Kurzschluss das Verhalten eines Viertelwellen-Resonators 24 eintritt. Diese Entladung führt zu einem steil einsetzenden und heftig oszillierenden Entladestrom auch über ein Koppelstück 16 zwischen Flaschenhals 17 und trichterförmig sich aufweitender Antenne 18 im rohrförmigen Umgehäuse 19. Die Bandbreite der Abstrahlung bzw. die Impulslänge des Entladestromes sind vor allem von durch die axiale Länge dieser konischen Antenne 18 gegeben. Die Schwerpunktfrequenz im abgestrahlten Spektrum wird in erster Linie durch die Länge des koaxialen Resonators 24 in Form des konzentrischen Elektrodenpaares 12-13 bestimmt, aber auch die Längenabmessungen des Flaschenhalses 17, des Koppelstückes 16 und der Antenne 18 gehen hier mit ein. Optimale Abstrahlleistung wird erzielt, wenn die mechanischen Abmessungen der Antenne 18 und der Außenelektrode 12 möglichst gut auf elektrische Resonanz mit dem Schwingungsverhalten des Resonators 24 abgestimmt sind.

Eine Frequenzbeeinflussung kann über die Beeinflussung der Zeitspanne erfolgen, die zum Abstrahlen der im Resonator 24 gespeicherten kapazitiven Energie erforderlich ist, also über die Pulslänge des Entladestromes und damit die Bandbreite dessen Spektrums. Das ist erfindungsgemäß realisierbar über die wirksame Länge der Antenne 18 selbst oder ihres Koppelstückes 16. Eine Verlängerung führt zu einem Absenken der Schwerpunktfrequenz im abgestrahlten Spektrum bei vergrößerter Bandbreite. Diese bedeutet eine Verkürzung des Impulses, allerdings bei Ansteigen seiner Amplitude. Das Koppelstück 16 wird dafür austauschbar oder einfacher noch wie skizziert teleskopierbar ausgebildet. Für die damit einhergehende Längsverlagerung der Antenne 18 ist diese mittels einer an ihre größere Trichterbasis sich anschließenden, axial kurzen hohlzylindrischen Manschette 20 im elektrisch isolierenden Umgehäuse 19 gelagert. Dabei bleibt eine elektrisch leitende Verbindung für den Strompfad über den Gleichstromgenerator 11 mittels eines Kontaktringes 21 auf der hohlzylindrischen Innenmantelfläche des Umgehäuses 19 sichergestellt.

Um aber ohne konstruktive Eingriffe in den Aufbau des Mikrowellengenerators 14 die Schwerpunktfrequenz in dessen Abstrahlspektrum zu beeinflussen, wird der Resonator 24 erfindungsgemäß bei variablem Reflektor-Abstand D zwischen zur Generator-Längsachse 22 parallel orientierten passiven Reflektoren 23 betrieben. Deren achsparallele Länge L sollte wenigstens derjenigen des Resonators 24 gleichkommen, vorzugsweise wie skizziert sich aber über die gesamte axiale Länge des Generators 14 erstrecken. Jedenfalls sollte die elektrische Eigenresonanz der Reflektoren 23 derjenigen des Resonators 24 möglichst gut entsprechen. Die Querabmessungen der Reflektoren 23 gehen dagegen nicht signifikant in das Abstrahlverhalten ein, weshalb hier keine Metallplatten erforderlich sind, sondern als Reflektoren 23 schon zwei einfache oder bevorzugt wie skizziert teleskopierbare Stäbe ausreichen, zwischen denen der Mikrowellengenerator 14 betrieben wird. Dessen wirksame Abstrahlung kann durch einfache Veränderung des Abstandes D zwischen den beiderseits angeordneten passiven Reflektoren 23 beeinflusst werden.

Der Frequenzschwerpunkt bzw. die Bandbreite der Abstrahlung eines impulsförmig arbeitenden Mikrowellengenerators 14 erfahren also erfindungsgemäß ohne Eingriff in den Aufbau des Generators 14 eine Verschiebung, wenn der Generator 14 zwischen zu ihm achsparallelen passiven Reflektoren 23 arbeitet, die in Axialrichtung auf Resonanz mit dem Generator 14 abgestimmt sein sollten, wofür eine Längenanpassung mittels Teleskopstäben zu bevorzugen ist. Frequenzbestimmend für die Abstrahlung ist aber in erster Linie der gegenseitige Abstand D dieser Reflektoren 23 - 23, zwischen denen der Generator 14 betrieben wird. Eine Abstandsverringerung führt zu einer Begrenzung der unteren Grenzfrequenz im Spektrum, unter Pulsverlängerung bei etwa gleich bleibender Amplitude was eine Energieverstärkung lediglich aufgrund Betriebes zwischen passiven Reflektoren 23 bedeutet.

Nach Auffinden gewünschter Resonanzbedingungen, etwa zum Einkoppeln der Mikrowellenenergie in externe Gebilde, kann diese Frequenzrelation durch Längenbemessung des vorzugsweise teleskopierbaren Koppelstückes 16 zwischen Resonator 24 und Antenne 18 fixiert werden.

## Patentansprüche

1. Frequenzvariierbarer Mikrowellengenerator (14) mit koaxialer Anordnung von kapazitivem Resonator (24) und Antenne (18) zu jeweils kurzzeitigem Abstrahlen eines energiereichen Spektrums gedämpfter Sinusschwingungen bei Entladen der Kapazität zwischen Außen- und Innen-Elektroden (12-13) des Resonators (24),
**dadurch gekennzeichnet,**
**dass** der Resonator (14) zwischen passiven Reflektoren (23) betrieben wird.

2. Mikrowellengenerator nach Anspruch 1,
**dadurch gekennzeichnet,**
**dass** der Abstand (D) zwischen den Reflektoren (23) variabel ist.

3. Mikrowellengenerator nach Anspruch 1 oder 2,
**dadurch gekennzeichnet,**
**dass** die Reflektoren (23) achsparallel zum Resonator (24) ausgerichtet sind.

4. Mikrowellengenerator nach dem vorangehenden Anspruch,
**dadurch gekennzeichnet,**
**dass** die Reflektoren (23) eine achsparallele Länge (L) von etwa derjenigen des Generators (14) aufweisen.

5. Mikrowellengenerator nach einem der vorangehenden Ansprüche,
**dadurch gekennzeichnet,**
**dass** die Reflektoren (24) eine einstellbare Länge (L) in Richtung parallel zur Generatorachse (22) aufweisen.

6. Mikrowellengenerator nach dem vorangehenden Anspruch,
**dadurch gekennzeichnet,**
**dass** die Reflektoren (23) als teleskopierbare Stäbe ausgelegt sind.

7. Frequenzvariierbarer Mikrowellengenerator (14) mit koaxialer Anordnung von kapazitivem Resonator (24) und Antenne (18) zu jeweils kurzzeitigem Abstrahlen eines energiereichen Spektrums gedämpfter Sinusschwingungen bei Entladen der Kapazität zwischen Außen- und Innen-Elektroden (12-13) des Resonators (24),
**dadurch gekennzeichnet,**
**dass** der Resonator (14) über wenigstens ein längenvariables Koppelstück (16) an die kleine Basis einer trichterförmigen Antenne (18) angeschlossen ist.

8. Mikrowellengenerator nach dem vorangehenden Anspruch,
**dadurch gekennzeichnet,**
**dass** ein teleskopierbares Koppelstück (15) vorgesehen ist.

9. Mikrowellengenerator nach einem der beiden vorangehenden Ansprüche,
**dadurch gekennzeichnet,**
**dass** die Antenne (18) elektrisch leitend an der Innenmantelfläche eines hohlzylindrischen Umgehäuses (19) axial verlagerbar gehaltert ist.

## Claims

1. Variable-frequency microwave generator (14) with a coaxial arrangement of a capacitive resonator (24) and antenna (18) for in each case brief emission of a high-energy spectrum of damped sinusoidal oscillations during the discharge of the capacitor between the outer and inner electrodes (12, 13) of the resonator (24), **characterized**
**in that** the resonator (24) is operated between passive reflectors (23).

2. Microwave generator according to Claim 1, **characterized**
**in that** the distance (D) between the reflectors (23) is variable.

3. Microwave generator according to Claim 1 or 2, **characterized**
**in that** the reflectors (23) are aligned with their axes parallel to the resonator (24).

4. Microwave generator according to the preceding claim,
**characterized**
**in that** the reflectors (23) have a length (L) parallel to the axis corresponding approximately to that of the generator (14).

5. Microwave generator according to one of the preceding claims,
**characterized**
**in that** the reflectors (23) have a variable length (L) in the direction parallel to the generator axis (22).

6. Microwave generator according to the preceding claim,
**characterized**
**in that** the reflectors (23) are in the form of telescopic rods.

7. Variable-frequency microwave generator (14) with a coaxial arrangement of a capacitive resonator (24) and antenna (18) for in each case brief emission of a high-energy spectrum of damped sinusoidal oscillations during the discharge of the capacitor between the outer and inner electrodes (12, 13) of the resonator (24), **characterized**
**in that** the resonator (24) is connected to the small base of a funnel-shaped antenna (18) via at least one variable-length coupling piece (16).

8. Microwave generator according to the preceding claim,
**characterized**
**in that** a telescopic coupling piece (15) is provided.

9. Microwave generator according to one of the two preceding claims,
**characterized**
**in that** the antenna (18) is mounted, such that it can be moved axially in an electrically conductive manner, on the inner casing surface of a hollow-cylindrical surrounding housing (19).

## Revendications

1. Générateur de micro-ondes (14) à fréquence variable qui présente une disposition coaxiale d'un résonateur capacitif (24) et d'une antenne (18) pour l'émission de courte durée correspondante d'un spectre fortement énergétique d'oscillations sinusoïdales atténuées lors de la décharge de la capacité entre les électrodes extérieure et intérieure (12, 13) du résonateur (24), **caractérisé en ce que** le résonateur (24) est utilisé entre des réflecteurs passifs (23).

2. Générateur de micro-ondes selon la revendication 1, **caractérisé en ce que** l'écart (D) entre les réflecteurs (23) est variable.

3. Générateur de micro-ondes selon la revendication 1 ou 2, **caractérisé en ce que** les réflecteurs (23) sont orientés avec les axes parallèles au résonateur (24).

4. Générateur de micro-ondes selon la revendication précédente, **caractérisé en ce que** les réflecteurs (23) présentent une longueur (L) parallèle aux axes approximativement égale à celle du générateur (14).

5. Générateur de micro-ondes selon l'une des revendications précédentes, **caractérisé en ce que** les
réflecteurs (23) présentent une longueur (L) réglable dans la direction parallèle à l'axe du générateur (22).

6. Générateur de micro-ondes selon la revendication précédente, **caractérisé en ce que** les réflecteurs (23) sont réalisés sous la forme de barres télescopiques.

7. Générateur de micro-ondes (14) à fréquence variable qui présente une disposition coaxiale d'un résonateur capacitif (24) et d'une antenne (18) pour l'émission de courte durée correspondante d'un spectre fortement énergétique d'oscillations sinusoïdales atténuées lors de la décharge de la capacité entre les électrodes extérieure et intérieure (12, 13) du résonateur (24), **caractérisé en ce que** le résonateur (24) est raccordé à la petite base d'une antenne en forme d'entonnoir (18) par le biais d'au moins une pièce d'accouplement (16) de longueur variable.

8. Générateur de micro-ondes selon la revendication précédente, **caractérisé en ce qu'**il est prévu une pièce d'accouplement télescopique (15).

9. Générateur de micro-ondes selon l'une des deux revendications précédentes, **caractérisé en ce que** l'antenne (18) est maintenue de manière électriquement conductrice et en pouvant être déplacée dans le sens axial sur la surface d'enveloppe intérieure d'un boîtier périphérique (19) cylindrique creux.
